# EUROPEAN PATENT APPLICATION

(11) **EP 4 435 859 A2**
(43) Date of publication of application: **25.09.2024**
(21) Application number: 23214718.1
(22) Date of filing: 06.12.2023
(51) Int. Cl.: H01L 27/02, H01L 21/8234, H01L 27/118

(54) **INTEGRATED CIRCUIT DEVICE WITH PERFORMANCE-ENHANCING LAYOUT**

(30) Priority: 22.03.2023 US 202318187782
(71) Applicant: Intel Corporation, Santa Clara, CA 95054 (US)
(72) Inventor: CHU, Tao, Portland, OR 97229 (US); JANG, Minwoo, Portland, OR 97229 (US); LUO, Yanbin, Portland, OR 97229 (US); PACKAN, Paul, Hillsboro, OR 97124 (US); XU, Guowei, Portland, OR 97229 (US); HUANG, Chiao-Ti, Portland, OR 97229 (US); CHAO, Robin, Portland, OR 97209 (US); ZHANG, Feng, Hillsboro, OR 97123 (US); MURTHY, Anand S., Portland, OR 97229 (US); GHANI, Tahir, Portland, OR 97229 (US)
(74) Representative: HGF

(57) **Abstract**

An IC device may include an array of transistors. The transistors may have separate gate electrodes. A gate electrode may include polysilicon. The gate electrodes may be separated from each other by one or more electrical insulators. The separated gate electrodes have shorter lengths, compared with connected gate electrodes, which can optimize the performance of the IC device due to local layout effect. Also, the IC device may include conductive structures crossing the support structures of multiple transistors. Such conductive structures may cause strain in the IC device, which can boost the local layout effect. The conductive structures may be insulated from a power plane. Alternatively or additionally, the IC device may include dielectric structures, which may be formed by removing gate electrodes in some of the transistors and providing a dielectric material into the openings. The presence of the dielectric structures can further boost the local layout effect.

## Description

### Background

Integrated circuit (IC) fabrication usually includes two stages. The first stage is referred to as the front end of line (FEOL). The second stage is referred to as the back end of line (BEOL). In the FEOL, individual semiconductor devices components (e.g., transistor, capacitors, resistors, etc.) can be patterned in a wafer. The physical layout of the semiconductor devices or their proximity to other features may impact the electrical characteristics of the semiconductor devices. In the BEOL, metal layers, vias, and insulating layers can be formed to get the individual components interconnected. The BEOL usually starts with forming the first metal layer on the wafer. The first metal layer is often called M0. More metal layers can be formed on top of M0, and these metal layers are often called M1, M2, and so on.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates an IC device comprising an FEOL section and a BEOL section, according to some embodiments of the disclosure.
FIG. 2 illustrates an IC device with long gate electrodes, according to some embodiments of the disclosure.
FIG. 3 illustrates an IC device with short gate electrodes, according to some embodiments of the disclosure.
FIG. 4 illustrates an IC device with dummy gates, according to some embodiments of the disclosure.
FIG. 5 illustrate an IC device with fin trim isolation (FTI) structures, according to some embodiments of the disclosure.
FIGS. 6A-6B are top views of a wafer and dies, according to some embodiments of the disclosure.
FIG. 7 is a side, cross-sectional view of an example IC package that may include one or more IC devices with performance-enhancing layout, according to some embodiments of the disclosure.
FIG. 8 is a cross-sectional side view of an IC device assembly that may include components having one or more IC devices with performance-enhancing layout, according to some embodiments of the disclosure.
FIG. 9 is a block diagram of an example computing device that may include one or more component with performance-enhancing layout, according to some embodiments of the disclosure.

### Detailed Description

The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

Many circuit devices include a large array of semiconductor devices, e.g., transistors. An example of these circuit device is Digital Linearity Voltage Regulator (DLVR). Examples of transistors in these circuit devices include MOSFET (metal-oxide-semiconductor field-effect transistor), such as NMOS (n-type metal-oxide-semiconductor) FET, PMOS (p-type metal-oxide-semiconductor) FET, and so on. However, the performance of a circuit device can be limited by the strength of its components, such as PMOS devices included in the circuit device. An example PMOS device may be a LVTP (low threshold voltage PMOS) or ULVTP (ultra low threshold voltage PMOS). The performance of the circuit can be impacted by local layout effects, i.e., environmental effects that can impact the electrical characteristics of a semiconductor device due to the physical layout of the circuit, such as proximity of the semiconductor device to other features in the circuit. Continued scaling of transistors creates additional challenges, as the scaling of transistors can introduce more and stronger local layout effects. For instance, the introduction or interaction of new materials in the transistors may cause strain on the transistors. Local layout effects can cause more variation in the performance of circuit devices.

Embodiments of the present disclosure may improve on at least some of the challenges and issues described above by utilizing local layout effects to enhance performance of IC devices. The layout of an IC device may be designed in a manner to improve the performance (e.g., to increase the operating current) of the IC device by taking advantage of local layout effects.

In various embodiments of the present disclosure, an IC device may include an array of transistors, in which the transistors may be arranged in one or more columns, or rows and columns. In an example, the transistors in a row may share a support structure that includes one or more semiconductor materials. The source, channel, and drain regions of the transistors may be different portions of the support structure. Each transistor may include a gate that is over the channel region. A gate may include an electrically conductive material, such as polysilicon, metal, and so on. The gates of the transistors (e.g., transistors in the same row or column) are separated from each other, e.g., by one or more electrical insulators. The separated gates have shorter lengths than connected gates. A connected gate may be over the channel regions of multiple transistors. The shorter gates can cause local layout effects (e.g., strain on the transistors) that can boost the performance of the transistors.

Local layout effects that can enhance performance of IC devices can be triggered by other layouts. In an example, an IC device may include one or more conductive structures that do not function as gates of any transistors. These conductive structures may be referred to as dummy, inactive, or idle conductive structures. These conductive structures may also be referred to as dummy, inactive, or idle gates. A dummy gate is not part of any transistor. A dummy gate is not electrically coupled to any power plane or ground plane. A dummy gate may include an electrically conductive material, such as polysilicon, metal, and so on. In some embodiments, the dummy gate may include the same material as the gate of a transistor. A dummy gate may across multiple support structures. The length of a dummy gate may be greater than the length of a gate of a transistor. In some embodiments, a dummy gate is placed at an edge of a logic cell, which may include a plurality of transistors. The logic cell may include another dummy gate, which may be placed at an opposing edge of the logic cell. The edges may be boundaries of the logic cell. A dummy gate may be at a boundary of two adjacent logic cells. The dummy gate(s) can also result in strain on the transistors and therefore boost the performance of the transistors.

In another example, an IC device may include one or more dielectric structures that can trigger local layout effects to enhance the performance of the IC device. A dielectric structure may be a FTI structure or a diffusion break structure. The dielectric structure may be formed by removing a gate of a transistor and filling the open area with one or more dielectric materials, e.g., nitride. The dielectric structure may be over the channel region of the transistor and between the source region and the drain region. As the gate is removed, the transistor may not function anymore, which sacrifices the area in the IC device. However, the dielectric structure can cause three-dimensional strain effect and trigger local layout effects in favor of the performance of the IC device. The performance enhancement caused by the dielectric structure can overcome the area sacrifice.

An IC device in the present disclosure may include one or more short gates, one or more dummy gates, one or more FTI structures, or some combination thereof. With the local layout effects caused by these components, the IC device may operate at a higher electrical current than currently available IC devices and therefore, have a better performance than the currently available IC devices. In some embodiments, the operating current of the IC device may be more than 10% or even more than 15% higher than the currently available IC devices.

It should be noted that, in some settings, the term "nanoribbon" has been used to describe an elongated semiconductor structure that has a substantially rectangular transverse cross-section (e.g., a cross-section in a plane perpendicular to the longitudinal axis of the structure), while the term "nanowire" has been used to describe a similar structure but with a substantially circular or square transverse cross-sections. In the following, a single term "nanoribbon" is used to describe an elongated semiconductor structure independent of the shape of the transverse cross-section. Thus, as used herein, the term "nanoribbon" is used to cover elongated semiconductor structures that have substantially rectangular transverse cross-sections (possibly with rounded corners), elongated semiconductor structures that have substantially square transverse cross-sections (possibly with rounded corners), elongated semiconductor structures that have substantially circular or elliptical/oval transverse cross-sections, as well as elongated semiconductor structures that have any polygonal transverse cross-sections.

In the following, some descriptions may refer to a particular source or drain (S/D) region or contact being either a source region/contact or a drain region/contact. However, unless specified otherwise, which region/contact of a transistor or diode is considered to be a source region/contact and which region/contact is considered to be a drain region/contact is not important because, as is common in the field of FETs, designations of source and drain are often interchangeable. Therefore, descriptions of some illustrative embodiments of the source and drain regions/contacts provided herein are applicable to embodiments where the designation of source and drain regions/contacts may be reversed.

As used herein, the term "metal layer" may refer to a layer above a substrate that includes electrically conductive interconnect structures for providing electrical connectivity between different IC components. Metal layers described herein may also be referred to as "interconnect layers" to clearly indicate that these layers include electrically conductive interconnect structures which may, but do not have to be, metal.

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 10%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 8% of a target value, e.g., within +/- 5% of a target value or within +/- 2% of a target value, based on the context of a particular value as described herein or as known in the art. Also, the term "or" refers to an inclusive "or" and not to an exclusive "or."

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

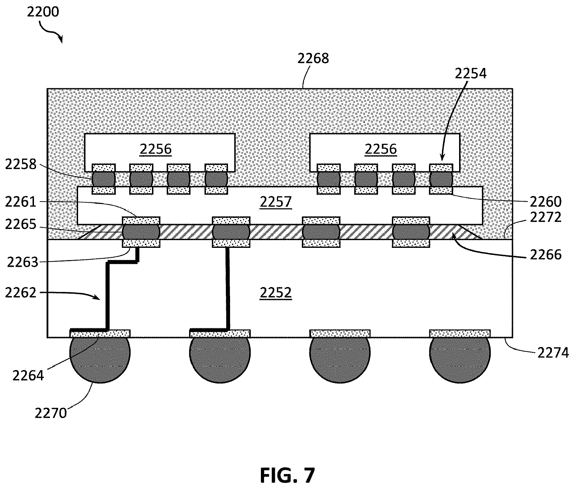

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense. For convenience, if a collection of drawings designated with different letters are present, e.g., FIGS. 7A-7B, such a collection may be referred to herein without the letters, e.g., as "FIG. 7."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of semiconductor devices with performance-enhancing layout as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC devices with performance-enhancing layout as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

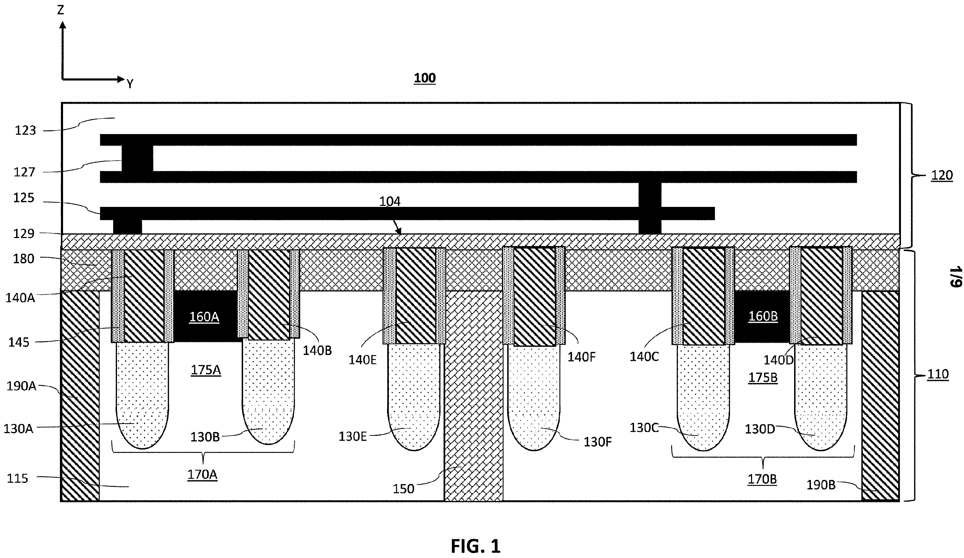

FIG. 1 illustrates an IC device 100 comprising an FEOL section 110 and a BEOL section 120, according to some embodiments of the disclosure. For the purpose of illustration, FIG. 1 shows a cross-sectional view of the IC device 100 in the Y-Z plane. The FEOL section 110 includes a support structure 115, a FTI structure 150, transistors 170A and 170B (collectively referred to as "transistors 170" or "transistor 170"), a dielectric layer 180, and conductive structures 190A and 190B (collectively referred to as "conductive structures 190" or "conductive structure 190"). The BEOL section 120 includes an insulative structure 123, metal layers 125 (individually referred to as "metal layer 115"), vias 127 (individually referred to as "via 117"), and a contact layer 129. In other embodiments, the IC device 100 may include fewer, more, or different components. For instance, the FEOL section 110 may include more transistors or other types of semiconductor devices, such as resistor, capacitor, inductor, etc. Also, the BEOL section 120 may include a different number of metal layers 125 or a different number of vias 127.

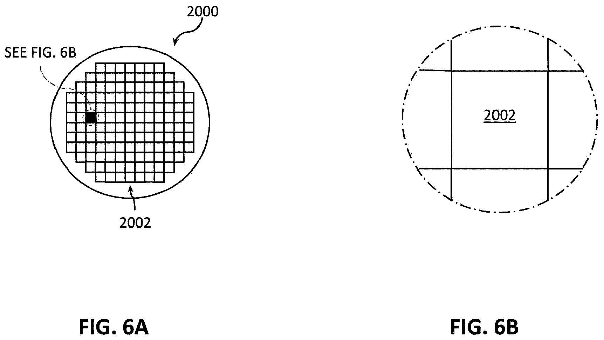

The support structure 115 may be any suitable structure, such as a substrate, a die, a wafer, or a chip, based on which transistors (such as the transistors 170) can be built. The support structure 115 may, e.g., be the wafer 2000 of FIG. 6A, discussed below, and may be, or be included in, a die, e.g., the singulated die 2002 of FIG. 6B, discussed below. In some embodiments, the support structure 115 may be a semiconductor substrate composed of semiconductor material systems including, for example, n-type or p-type materials systems.

Semiconductor regions 130A-130F (collectively referred to as "semiconductor regions 130" or "semiconductor region 130") may be formed based on the support structure 115. In some embodiments, one or more semiconductor structures may be formed, e.g., through epitaxial growth of one or more semiconductor materials. The semiconductor regions 130 may be formed by doping certain portions of the one or more semiconductor structures. A portion of the support structure 115 that is between a pair of semiconductor regions 130 (e.g., the semiconductor regions 130A and 130B or the semiconductor regions 130C and 130D) may be a channel region of a transistor 170. Even though the semiconductor regions 130 are in the same support structure 115 in FIG. 1, the semiconductor regions 130 may be in different support structures in other embodiments.

In some embodiments, the semiconductor substrate may be a crystalline substrate formed using a bulk silicon or a silicon-on-insulator substructure. In other embodiments, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. In some embodiments, the support structure may be a printed circuit board (PCB) substrate. One or more transistors, such as the transistors 170, may be built on the support structure 115.

Although a few examples of materials from which the support structure 115 may be formed are described here, any material that may serve as a foundation upon which an IC may be built falls within the spirit and scope of the present disclosure. In various embodiments, the support structure 115 may include any such substrate, possibly with some layers and/or devices already formed thereon, not specifically shown in the present figures. As used herein, the term "support" does not necessarily mean that it provides mechanical support for the IC devices/structures (e.g., transistors, capacitors, interconnects, and so on) built thereon. For example, some other structure (e.g., a carrier substrate or a package substrate) may provide such mechanical support and the support structure 115 may provide material "support" in that, e.g., the IC devices/structures described herein are build based on the semiconductor materials of the support structure 115. However, in some embodiments, the support structure 115 may provide mechanical support.

A transistor 170 may be a FET, such as MOSFET, tunnel FET (TFET), fin-based transistor (e.g., FinFET), nanoribbon-based transistor, gate-all-around (GAA) transistor, other types of FET, or some combination thereof. A transistor 170 includes a semiconductor structure that includes a channel region, a source region, and a drain region. The semiconductor structure of the transistor 170 may be at least partially in the support structure 115. The support structure 115 may include a semiconductor material, from which at least a portion of the semiconductor structure is formed. The semiconductor structure of the transistor 170 (or a portion of the semiconductor structure, e.g., the channel region) may be a planar structure or a non-planar structure. A non-planar structure is a three-dimensional structure, such as fin, nanoribbon (e.g., nanosheet, nanowire, etc.), and so on. A non-planar structure may have a longitudinal axis and a transvers cross-section perpendicular to the longitudinal axis. In some embodiments, a dimension of the non-planar structure along the longitudinal axis may be greater than dimensions along other directions, e.g., directions along axes perpendicular to the longitudinal axis.

In the embodiments of FIG. 1, the source and drain regions of the transistors 170 are some of the semiconductor regions 130. In an example, the semiconductor region 130A is the source region of the transistor 170A, the semiconductor region 130B is the drain region of the transistor 170A, semiconductor region 130C is the source region of the transistor 170B, and the semiconductor region 130D is the drain region of the transistor 170B. A semiconductor region 175A, which is under the gate 160A and is between the semiconductor regions 130A and 130B, constitute the channel region of the transistor 170A. A semiconductor region 175B, which is under the gate 160B and is between the semiconductor regions 130C and 130D, constitute the channel region of the transistor 170B. The semiconductor region 175 A or 175B may be a part of the support structure 115.

A channel region may include a channel material. The channel material may be composed of semiconductor material systems including, for example, n-type or p-type materials systems. In some embodiments, the channel material may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the channel material may include a compound semiconductor with a first sub-lattice of at least one element from Group III of the periodic table (e.g., Al, Ga, In), and a second sub-lattice of at least one element of group V of the periodic table (e.g., P, As, Sb). In some embodiments, the channel material may include a compound semiconductor with a first sub-lattice of at least one element from Group II of the periodic table (e.g., Zn, Cd, Hg), and a second sub-lattice of at least one element of Group IV of the periodic table (e.g., C, Si, Ge, Sn, Pb). In some embodiments, the channel material is an epitaxial semiconductor material deposited using an epitaxial deposition process. The epitaxial semiconductor material may have a polycrystalline structure with a grain size between about 2 nm and 100 nm, including all values and ranges therein.

For some example n-type transistor embodiments (i.e., for the embodiments where the transistor 170 is an NMOS transistor or an n-type TFET), the channel material may advantageously include a III-V material having a high electron mobility, such as, but not limited to InGaAs, InP, InSb, and InAs. For some such embodiments, the channel material may be a ternary III-V alloy, such as InGaAs, GaAsSb, InAsP, or InPSb. For some InxGa1-xAs fin embodiments, In content (x) may be between 0.6 and 0.9, and may advantageously be at least 0.7 (e.g., In0.7Ga0.3As). In some embodiments with highest mobility, the channel material may be an intrinsic III-V material, i.e., a III-V semiconductor material not intentionally doped with any electrically active impurity. In alternate embodiments, a nominal impurity dopant level may be present within the channel material, for example to further fine-tune a threshold voltage Vt, or to provide HALO pocket implants, etc. Even for impurity-doped embodiments however, impurity dopant level within the channel material may be relatively low, for example below 10¹⁵ dopant atoms per cubic centimeter (cm⁻³), and advantageously below 10¹³ cm⁻³. These materials may be amorphous or polycrystalline, e.g., having a crystal grain size between 0.5 nanometers and 100 nanometers.

For some example p-type transistor embodiments (i.e., for the embodiments where the transistor 170 is a PMOS transistor or a p-type TFET), the channel material may advantageously be a Group IV material having a high hole mobility, such as, but not limited to Ge or a Ge-rich SiGe alloy. For some example embodiments, the channel material may have a Ge content between 0.6 and 0.9, and advantageously may be at least 0.7. In some embodiments with highest mobility, the channel material may be intrinsic III-V (or IV for p-type devices) material and not intentionally doped with any electrically active impurity. In alternate embodiments, one or more a nominal impurity dopant level may be present within the channel material, for example to further set a threshold voltage (Vt), or to provide HALO pocket implants, etc. Even for impurity-doped embodiments however, impurity dopant level within the channel portion is relatively low, for example below 10¹⁵ cm⁻³, and advantageously below 10¹³ cm⁻³. These materials may be amorphous or polycrystalline, e.g., having a crystal grain size between 0.5 nanometers and 100 nanometers.

In some embodiments, the channel material may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, aluminum zinc oxide, or tungsten oxide. In general, for a thin-film transistor (TFT), the channel material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, molybdenum disulfide, n- or p-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc. In some embodiments, a thin-film channel material may be deposited at relatively low temperatures, which allows depositing the channel material within the thermal budgets imposed on back-end fabrication to avoid damaging other components, e.g., front end components such as logic devices.

As noted above, the channel material may include IGZO. IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors.

IGZO can be deposited as a uniform amorphous phase while retaining higher carrier mobility than oxide semiconductors such as zinc oxide. Different formulations of IGZO include different ratios of indium oxide, gallium oxide, and zinc oxide. One particular form of IGZO has the chemical formula InGaO₃(ZnO)₅. Another example form of IGZO has an indium:gallium:zinc ratio of 1:2:1. In various other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminum or nitrogen.

The source region and drain region in a transistor 170 are connected to the channel region. The source region and drain region may each include a semiconductor material with dopants. In some embodiments, the source region and drain region have the same semiconductor material, which may be the same as the channel material of the channel region. A semiconductor material of the source region or the drain region may be a Group IV material, a compound of Group IV materials, a Group III/V material, a compound of Group III/V materials, a Group II/VI material, a compound of Group II/VI materials, or other semiconductor materials. Example Group II materials include zinc (Zn), cadmium (Cd), and so on. Example Group III materials include aluminum (Al), boron (B), indium (In), gallium (Ga), and so on. Example Group IV materials include silicon (Si), germanium (Ge), carbon (C), etc. Example Group V materials include nitrogen (N), phosphorus (P), arsenic (As), antimony (Sb), and so on. Example Group VI materials include sulfur (S), selenium (Se), tellurium (Te), oxygen (O), and so on. A compound of Group IV materials can be a binary compound, such as SiC, SiGe, and so on. A compound of Group III/V materials can be a binary, tertiary, or quaternary compound, such as GaN, InN, and so on. A compound of Group II/VI materials can be a binary, tertiary, or quaternary compounds, such as CdSe, CdS, CdTe, ZnO, ZnSe, ZnS, ZnTe, CdZnTe, CZT, HgCdTe, HgZnTe, and so on.

In some embodiments, the dopants in the source region and the drain region are the same type. In other embodiments, the dopants of the source region and the drain region may be different (e.g., opposite) types. In an example, the source region has n-type dopants and the drain region has p-type dopants. In another example, the source region has p-type dopants and the drain region has n-type dopants. Example n-type dopants include Te, S, As, tin (Sn), Si, Ga, Se, S, In, Al, Cd, chlorine (Cl), iodine (I), fluorine (F), and so on. Example p-type dopants include beryllium (Be), Zn, magnesium (Mg), Sn, P, Te, lithium (Li), sodium (Na), Ga, Cd, and so on.

In some embodiments, the source region and the drain region may be highly doped, e.g., with dopant concentrations of about 1·10²¹ cm⁻³, in order to advantageously form Ohmic contacts with the respective S/D contacts (also sometimes interchangeably referred to as "S/D electrodes"), although these regions may also have lower dopant concentrations and may form Schottky contacts in some implementations. Irrespective of the exact doping levels, the source region and the drain region may be the regions having dopant concentration higher than in other regions, e.g., higher than a dopant concentration in the channel region, and, therefore, may be referred to as "highly doped" (HD) regions.

The channel region may include one or more semiconductor materials with doping concentrations significantly smaller than those of the source region and the drain region. For example, in some embodiments, the channel material of the channel region may be an intrinsic (e.g., undoped) semiconductor material or alloy, not intentionally doped with any electrically active impurity. In alternate embodiments, nominal impurity dopant levels may be present within the channel material, for example to set a threshold voltage Vt, or to provide HALO pocket implants, etc. In such impurity-doped embodiments however, impurity dopant level within the channel material is still significantly lower than the dopant level in the source region and the drain region, for example below 10¹⁵ cm⁻³ or below 10¹³ cm⁻³. Depending on the context, the term "S/D terminal" may refer to a S/D region or a S/D contact or electrode of a transistor.

The transistor 170 also includes a source contact over the source region and a drain contact over the drain region. The source contact and drain contact are also referred to as trench contacts. FIG. 1 shows four trench contacts 140A-140D (collectively referred to as "trench contacts 140" or "trench contact 140"), which are coupled to a semiconductor region 130A-130D, respectively. A trench contact 140 may include one or more electrically conductive materials to couple the semiconductor region 130 to a power plane or ground plane, which may be one or more metal layers 125 in the BEOL section 120. An electrically conductive material may be metal. Examples of metals in the trench contacts 140 may include, but are not limited to, Ru, Cu, Co, palladium (Pd), platinum (Pt), nickel (Ni), and so on. In the embodiments of FIG. 1, each trench contact 140 is wrapped around by a spacer 145. The spacer 145 may be electrically insulative. The spacer 145 may include an electrical insulator, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc. The spacer 145 can insulate the trench contact 140 from other electrically conductive structures, such as gates 160A and 160B (collectively referred to as "gates 160" or "gate 160")

Each transistor 170 includes a gate 160 that is over or wraps around at least a portion of the channel region of the transistor 170. The gate 160 is between the semiconductor regions 130 of the transistor in the direction along the Y axis. A gate 160 can be coupled to a gate terminal that controls gate voltages applied on the transistor 170. In the embodiments of FIG. 1, the gates 160 are separated from each other. In some embodiments, the gates 160 are insulated from each other by one or more electrical insulators. Compared with embodiments where a gate is connected to one or more other gates, which forms a larger conductive structure, the gates 160 in FIG. 1 have smaller dimensions and result in local layout effects that can improve the performance of the IC device 100. For instance, the IC device 100 may have a higher limit for its operating current level.

The gate 160 may include one or more gate electrode materials, such as polysilicon, metal, and so on. The choice of the gate electrode materials may depend on whether the transistor 170 is a p-type transistor or an n-type transistor. For a p-type transistor, gate electrode materials that may be used in different portions of the gate electrode may include, but are not limited to, Ru, Pd, Pt, Co, Ni, and conductive metal oxides (e.g., ruthenium oxide). For an n-type transistor, gate electrode materials that may be used in different portions of the gate electrode, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate 160 may include a stack of a plurality of gate electrode materials, where zero or more materials of the stack are workfunction (WF) materials and at least one material of the stack is a fill metal layer. Further materials/layers may be included next to the gate electrode for other purposes, such as to act as a diffusion barrier layer or/and an adhesion layer.

Even though not shown in FIG. 1, a gate 160 may also include a gate insulator that separates at least a portion of the channel region from each gate electrode so that the channel region is insulated from the gate electrode. In some embodiments, the gate insulator may wrap around at least a portion of the channel region. The gate insulator may also wrap around at least a portion of the source region or the drain region. At least a portion of the gate insulator may be wrapped around by the gate electrode. The gate insulator includes an electrical insulator, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc.

The FTI structure 150 is between the transistor 170A and the transistor 170B. The FTI structure 150 separates the transistor 170A from the transistor 170B. The FTI structure 150 includes one or more dielectric materials that can prevent current leakage (e.g., diffusion of charges) between the two transistors 170. The one or more dielectric materials may include an oxide, nitride, carbide, other types of dielectric materials, or some combination thereof. Example dielectric materials may include silicon oxide (SiO), silicon oxycarbide (SiOC), silicon oxycarbonitride (SiOCN), silicon nitride (SiN), silicon carbide (SiC), silicon carbonitride (SiCN), and so on.

As shown in FIG. 1, a portion of the FTI structure 150 is between the semiconductor regions 130E and 130F, and another portion of the FTI structure 150 is between trench contacts 140E and 140F. The semiconductor regions 130E and 130F may be the same or similar as the other semiconductor regions 130. The trench contacts 140E and 140F may be the same or similar as one or more of the trench contacts 140A-140D. The FTI structure 150 may be formed by depositing a dielectric material into an opening formed by removing the gate of a transistor between transistor 170A and the transistor 170B. After the gate is removed and replaced with the FTI structure 150, the IC device 100 loses a functional transistor but can gain better performance due to local layout effects caused by the FTI structure 150. The local layout effects can make the transistors 170A and 170B to operate at a higher electrical current.

In some embodiments, the dielectric structure 155 may have the same material as the dielectric layer 180. The dielectric layer 180 is between the gates 160 and the contact layer 129 in the BEOL section 120. The dielectric layer 180 may insulate the trench contacts 140 from each other. The dielectric layer 180 may also separate and insulate the gates 160 from the contact layer 129. The dielectric layer 180 may contact the bottom surface of the contact layer 129. The contact layer 129 may be electrically conductive. In the embodiments of FIG. 1, different portions of the contact layer 129 contacts the top surfaces of the trench contacts 140, respectively. Electrical signals can be provided to the trench contacts 140 and further to the semiconductor regions 130 through the contact layer 129. The contact layer 129 is electrically coupled to the metal layers 125 through the vias 127.

The metal layers 125 may facilitate supply of electrical signals to the transistor 170. Even though not shown in FIG. 1, the metal layers 125 may be coupled with other devices than the transistor 170, such as diodes, power sources, resistors, capacitors, inductors, sensors, transceivers, receivers, antennas. A via 127 may include a metal, such as tungsten (W), molybdenum (Mo), ruthenium (Ru), or other metals. Different vias 127 may include different materials. The vias 127 can provide a conductive channel between the metal layers 125. The metal layers 125, vias 127, or contact layer 129 may be partially or wholly surrounded by the insulative structure 123. Certain portions of the metal layers 125, vias 127, or contact layer 129 may be insulated by the insulative structure 123. The insulative structure 123 may include one or more electrical insulators. An electrical insulator may be a dielectric material, hysteretic material, and so on. Example dielectric material includes oxide (e.g., Si based oxides, metal oxides, etc.), low-k dielectric, high-k dielectric, and so on. Example hysteretic material include ferroelectric materials, antiferroelectric materials, etc.

The conductive structures 190 are dummy gates in the IC device 100. For instance, the conductive structures 190 are not electrically coupled to any of the metal layers 125. There may be no electrical current going through the conductive structures 190 during the operation of the IC device 100. As shown in FIG. 1, the conductive structures 190 are longer than the gates 160 along the Z axis. The dimension of the conductive structures 190 in another direction (e.g., along the Y axis or along an X axis that is perpendicular to the Y and Z axes) may be larger than the dimension of a gate 160 in the direction. The addition of the conductive structures 190 can lead to local layout effects that can enhance the performance of the transistors 170. In some embodiments, the conductive structures 190 are at two opposing edges of a logic cell that includes the transistors 170.

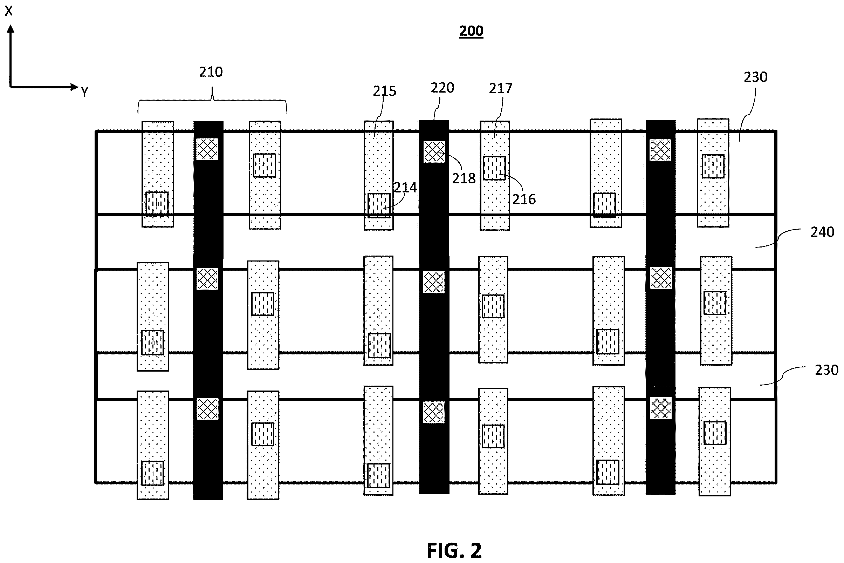

FIG. 2 illustrates an IC device 200 with long gate electrodes 220 (individually referred to as "gate electrode 220"), according to some embodiments of the disclosure. The IC device 200 also includes an array of transistors 210 (individually referred to as "transistor 210"). The IC device also includes three semiconductor structures 230 (individually referred to as "semiconductor structure 230") and electrical insulators 240 (individually referred to as "electrical insulator 240"). The IC device 200 may be an example of currently available IC devices without performance-enhancing layouts.

A transistor 210 may be a MOSFET, such as p-MOSFET or n-MOSFET. In some embodiments, the transistors 210 may be the same type of transistor. In other embodiments, the transistors 210 may be different types of transistors. In the embodiments of FIG. 2, the nine transistors 210 are arranged in three rows and three columns. In other embodiments, the IC device 200 may include a different number of transistors. Also, the arrangement of the transistors may be different. The transistors 210 in the same column share a gate electrode 220. For instance, a portion of the gate electrode 220 constitute the gate electrode of an individual transistor 210. The portion of the gate electrode 220 is between a source region 215 and a drain region 217 of the transistor 210 along the Y axis.

Even though not shown in FIG. 2, the transistor 210 may also include a channel region that is between the source region 215 and the drain region 217 along the Y axis and over the portion of the gate electrode 220 along a Z axis that is perpendicular to the X and Y axes. The transistor 210 also includes a source contact 214, a drain contact 216, and a gate contact 218. The source contact 214 is electrically coupled to the source region 215. The source contact 214 can electrically couple the source region 215 to a power panel, such as a metal layer. In some embodiments, the source contact 214 may contact the source region 215. The drain contact 216 is electrically coupled to the drain region 217. The drain contact 216 can electrically couple the drain region 217 to a power panel, such as a metal layer. In some embodiments, the drain contact 216 may contact the drain region 217. The gate contact 218 is electrically coupled to the gate electrode 220. The gate contact 218 can electrically couple the gate electrode 220 to a power panel, such as a metal layer. In some embodiments, the gate contact 218 may contact the gate electrode 220.

The semiconductor regions (e.g., the source region 215, drain region 217, and the channel region) of each transistor 210 may be formed based on a semiconductor structure 230. The semiconductor structure 230 includes one or more semiconductor materials. In some embodiments (e.g., embodiment where the transistors 210 are p-MOSFET), the semiconductor structure 230 may include one or more p-type semiconductor materials. In other embodiments (e.g., embodiment where the transistors 210 are n-MOSFET), the semiconductor structure 230 may include one or more n-type semiconductor materials. The semiconductor structure 230 may be formed by epitaxial growth of one or more semiconductor materials.

In some embodiments, a semiconductor region (e.g., the channel region) of a transistor 210 may be part of the semiconductor structure 230. The source region 215 or the drain region 217 may be formed by doping a portion of the semiconductor structure 230. As shown in FIG. 2, a semiconductor structure 230 is associated with three transistors 210 that are arranged in a row. In other embodiments, a semiconductor structure 230 may be used to form a different number of transistors 210. A semiconductor structure 230 may be a planar structure or non-planar structure (e.g., fin, nanoribbon, etc.).

An electrical insulator 240 is between two adjacent semiconductor structures 230. Each electrical insulator 240 may include one or more electrical insulative materials, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc.

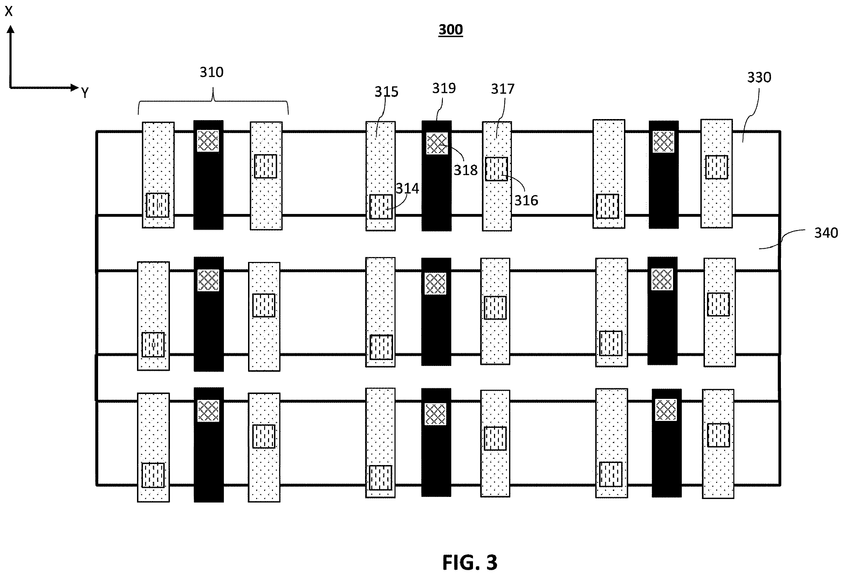

FIG. 3 illustrates an IC device 300 with short gate electrodes 319 (individually referred to as "gate electrode 319"), according to some embodiments of the disclosure. The IC device 300 includes an array of transistors 310 (individually referred to as "transistor 310"). A transistor 310 may be an embodiment of the transistor 170 in FIG. 1. The IC device 300 also includes three semiconductor structures 330 (individually referred to as "semiconductor structure 330") and electrical insulators 340 (individually referred to as "electrical insulator 340"). In other embodiments, the IC device 300 may include fewer, more, or different components. The IC device 300 may be an embodiment of the IC device 100 in FIG. 1.

A transistor 310 may be a MOSFET, such as p-MOSFET or n-MOSFET. In some embodiments, the transistors 310 may be the same type of transistor. In other embodiments, the transistors 310 may be different types of transistors. In the embodiments of FIG. 3, the nine transistors 310 are arranged in three rows and three columns. In other embodiments, the IC device 300 may include a different number of transistors. Also, the arrangement of the transistors may be different. Each transistor 310 includes a source region 315, a drain region 317, a gate electrode 319 between the source region 315 and the drain region 317 in a direction along the Y axis.

Different from the layout of the IC device 200 in FIG. 2, the IC device 300 in FIG. 3 has a layout where all the transistors 310 have separated gate electrodes, i.e., each transistor 310 has a gate electrode 319 that is separated from other gate electrodes 319 of other transistors 310, including transistors 310 that are in the same column. With such a layout, the gate electrodes 319 are shorter than the gate electrodes 220 along the X axis, which is perpendicular or substantially perpendicular to the Y axis. The layout with shorter gate electrodes 319 has local layout effects that can enhance the performance of the transistors 310. Compared with the IC device 200, the IC device 300 has better performance. For instance, the IC device 200 may operate at a higher current than the IC device 200.

Even though not shown in FIG. 3, the transistor 310 may also include a channel region that is between the source region 315 and the drain region 317 along the Y axis and over the portion of the gate electrode 319 along a Z axis that is perpendicular to the X and Y axes. The transistor 310 also includes a source contact 314, a drain contact 316, and a gate contact 318. The source contact 314 is electrically coupled to the source region 315. The source contact 314 can electrically couple the source region 315 to a power panel, such as a metal layer. In some embodiments, the source contact 314 may contact the source region 315. The drain contact 316 is electrically coupled to the drain region 317. The drain contact 316 can electrically couple the drain region 317 to a power panel, such as a metal layer. In some embodiments, the drain contact 316 may contact the drain region 317. The gate contact 318 is electrically coupled to the gate electrode 319. The gate contact 318 can electrically couple the gate electrode 319 to a power panel, such as a metal layer. In some embodiments, the gate contact 318 may contact the gate electrode 319.

The semiconductor regions (e.g., the source region 315, drain region 317, and the channel region) of each transistor 310 may be formed based on a semiconductor structure 330. The semiconductor structure 330 includes one or more semiconductor materials. In some embodiments (e.g., embodiment where the transistors 310 are p-MOSFET), the semiconductor structure 330 may include one or more p-type semiconductor materials. In other embodiments (e.g., embodiment where the transistors 310 are n-MOSFET), the semiconductor structure 330 may include one or more n-type semiconductor materials. The semiconductor structure 330 may be formed by epitaxial growth of one or more semiconductor materials.

In some embodiments, a semiconductor region (e.g., the channel region) of a transistor 310 may be part of the semiconductor structure 330. The source region 315 or the drain region 317 may be formed by doping a portion of the semiconductor structure 330. As shown in FIG. 3, a semiconductor structure 330 is associated with three transistors 310 that are arranged in a row. In other embodiments, a semiconductor structure 330 may be used to form a different number of transistors 310. A semiconductor structure 330 may be a planar structure or non-planar structure (e.g., fin, nanoribbon, etc.).

An electrical insulator 340 is between two adjacent semiconductor structures 330. Each electrical insulator 340 may include one or more electrical insulative materials, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc. FIG. 3 shows two electrical insulators 440. In other embodiments, the IC device 300 may include a different number of electrical insulator(s).

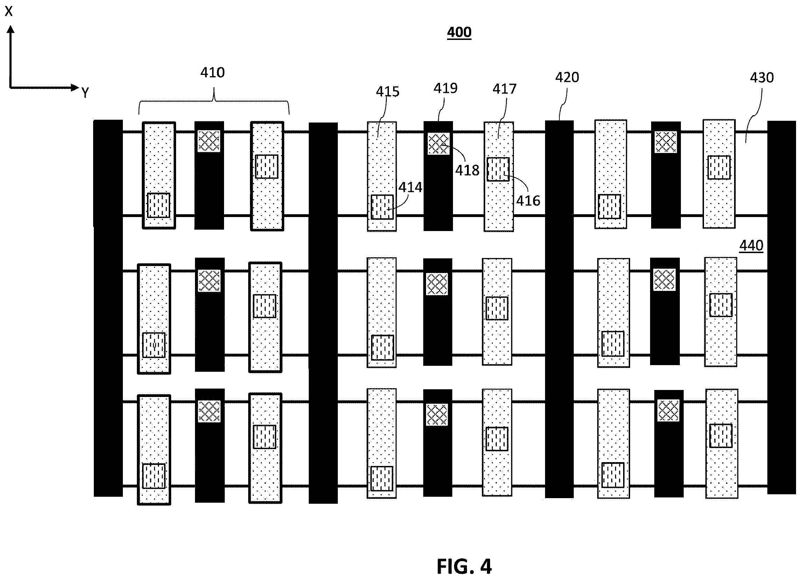

FIG. 4 illustrates an IC device 400 with dummy gates 420 (individually referred to as "dummy gate 420"), according to some embodiments of the disclosure. The IC device 400 includes an array of transistors 410 (individually referred to as "transistor 410"). A transistor 410 may be an embodiment of the transistor 170 in FIG. 1 or a transistor 310 in FIG. 3. The IC device 400 also includes three semiconductor structures 430 (individually referred to as "semiconductor structure 430") and electrical insulators 440 (individually referred to as "electrical insulator 440"). In other embodiments, the IC device 400 may include fewer, more, or different components. The IC device 400 may be an embodiment of the IC device 100 in FIG. 1.

A transistor 410 may be a MOSFET, such as p-MOSFET or n-MOSFET. In some embodiments, the transistors 410 may be the same type of transistor. In other embodiments, the transistors 410 may be different types of transistors. In the embodiments of FIG. 4, the nine transistors 410 are arranged in three rows and three columns. In other embodiments, the IC device 400 may include a different number of transistors. Also, the arrangement of the transistors may be different. Each transistor 410 includes a source region 415, a drain region 417, a gate electrode 419 between the source region 415 and the drain region 417 in a direction along the Y axis.

Different from the layout of the IC device 200 in FIG. 2, the IC device 400 in FIG. 4 has a layout where all the transistors 410 have separated gate electrodes, i.e., each transistor 410 has a gate electrode 419 that is separated from other gate electrodes 419 of other transistors 410, including transistors 410 that are in the same column. With such a layout, the gate electrodes 419 are shorter than the gate electrodes 220 along the X axis, which is perpendicular or substantially perpendicular to the Y axis. The layout with shorter gate electrodes 419 has local layout effects that can enhance the performance of the transistors 410.

The dummy gates 420 can cause additional local layout effects or enhance the local layout effects caused by the short gate electrodes 419. Each dummy gates 420 extends across the three semiconductor structures 430 along the X axis and is longer than an individual gate electrode 419. In other embodiments, a dummy gate 420 may have a different length along the X axis than the length shown in FIG. 4. Each column of transistors 410 is associated with two adjacent dummy gates 420, with the three transistors 410 between the two dummy gates 420. Each of the two dummy gates 420 in the middle are shared by two columns. A column may constitute a logic cell of the IC device. In some embodiments, the dummy gates 420 define the boundaries of the columns. The most left dummy gate 420 and the most right dummy gate 420 may define the boundaries of the IC device 400. With the local layout effects caused by the shorter gate electrodes 419 and the dummy gates 420, the IC device 400 can have better performance than the IC device 200 or even better performance than the IC device 300.

Even though not shown in FIG. 4, the transistor 410 may also include a channel region that is between the source region 415 and the drain region 417 along the Y axis and over the portion of the gate electrode 419 along a Z axis that is perpendicular to the X and Y axes. The transistor 410 also includes a source contact 414, a drain contact 416, and a gate contact 418. The source contact 414 is electrically coupled to the source region 415. The source contact 414 can electrically couple the source region 415 to a power panel, such as a metal layer. In some embodiments, the source contact 414 may contact the source region 415. The drain contact 416 is electrically coupled to the drain region 417. The drain contact 416 can electrically couple the drain region 417 to a power panel, such as a metal layer. In some embodiments, the drain contact 416 may contact the drain region 417. The gate contact 418 is electrically coupled to the gate electrode 419. The gate contact 418 can electrically couple the gate electrode 419 to a power panel, such as a metal layer. In some embodiments, the gate contact 418 may contact the gate electrode 419.

The semiconductor regions (e.g., the source region 415, drain region 417, and the channel region) of each transistor 410 may be formed based on a semiconductor structure 430. The semiconductor structure 430 includes one or more semiconductor materials. In some embodiments (e.g., embodiment where the transistors 410 are p-MOSFET), the semiconductor structure 430 may include one or more p-type semiconductor materials. In other embodiments (e.g., embodiment where the transistors 410 are n-MOSFET), the semiconductor structure 430 may include one or more n-type semiconductor materials. The semiconductor structure 430 may be formed by epitaxial growth of one or more semiconductor materials.

In some embodiments, a semiconductor region (e.g., the channel region) of a transistor 410 may be part of the semiconductor structure 430. The source region 415 or the drain region 417 may be formed by doping a portion of the semiconductor structure 430. As shown in FIG. 4, a semiconductor structure 430 is associated with three transistors 410 that are arranged in a row. In other embodiments, a semiconductor structure 430 may be used to form a different number of transistors 410. A semiconductor structure 430 may be a planar structure or non-planar structure (e.g., fin, nanoribbon, etc.).

An electrical insulator 440 is between two adjacent semiconductor structures 440. Each electrical insulator 440 may include one or more electrical insulative materials, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc. FIG. 4 shows two electrical insulators 440. In other embodiments, the IC device 400 may include a different number of electrical insulator(s).

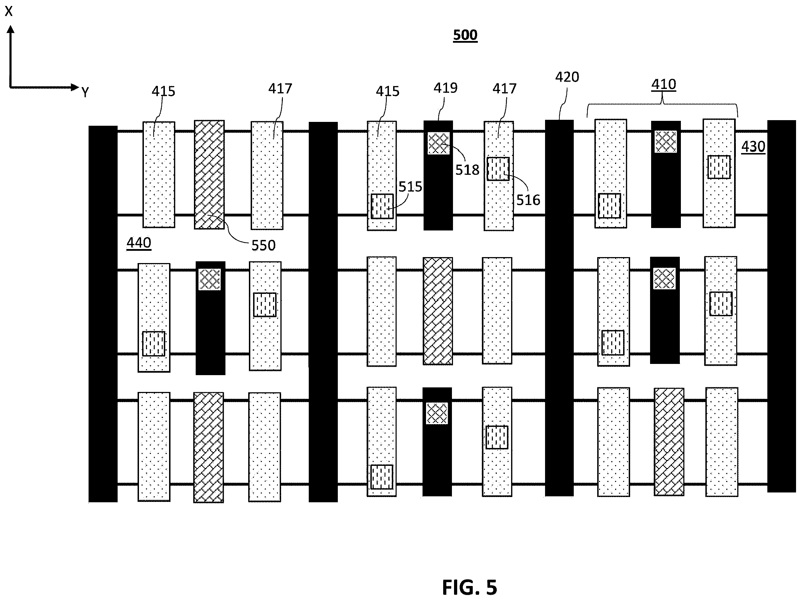

FIG. 5 illustrate an IC device 500 with FTI structures 550 (individually referred to as "FTI structure 550"), according to some embodiments of the disclosure. In some embodiments, the IC device 400 may be fabricated based on the IC device 400 in FIG. 4. For instance, the IC device 500 is formed by removing the gate electrodes 419 in four transistors 410 in the IC device 400. The removal of the four gate electrodes 419 results in four opening areas. Further, the opening areas may be filled with one or more dielectric materials to form the FTI structures 550. The one or more dielectric materials may include oxide, nitride, carbide, and so on. Each FTI structure 550 is between a source region 415 and a drain region 417. In some embodiments, the length of a FTI structure 550 along the X axis may be the same or similar as the length of a gate electrode 419 along the X axis. The four transistors 410 are converted into inactive components of the IC device 500. The other five transistors 410 may remain functional. In other embodiments, the FTI structures 550 may be formed without removing any gate electrodes 419.

The FTI structures 550 may further boost local layout effects that can improve the performance of the IC device 500, despite the decrease in the number of transistors 410. For instance, the performance of the middle transistor 410 in the left column may be enhanced by the two FTI structures 550 in the left column. The performance of the top and bottom transistors 410 in the middle column may be enhanced by the FTI structure 550 that is between these two transistors 410. In the right column, the performance of the two transistors 410 (or one of the two transistors) may be enhanced by the FTI structure 550 that is below the two transistors.

Even though FIG. 5 shows four FTI structures 550, the IC device 500 may include a different number of FTI structure(s). Also, the positions of the FTI structures 550 may be different from the layout illustrated in FIG. 5. Further, in some embodiments, the IC device 500 may include less or even none dummy gates. Additionally or alternatively, the IC device 500 may include one or more long gate electrodes (e.g., the gate electrodes 220 in FIG. 2) in lieu of some or all of the short gate electrodes 419.

FIGS. 6A-6B are top views of a wafer 2000 and dies 2002, according to some embodiments of the disclosure. In some embodiments, the dies 2002 may be included in an IC package, according to some embodiments of the disclosure. For example, any of the dies 2002 may serve as any of the dies 2256 in an IC package 2200 shown in FIG. 7. The wafer 2000 may be composed of semiconductor material and may include one or more dies 2002 having IC devices formed on a surface of the wafer 2000. Each of the dies 2002 may be a repeating unit of a semiconductor product that includes any suitable IC (e.g., ICs with performance enhanced by local layout effect as described herein). After the fabrication of the semiconductor product is complete, the wafer 2000 may undergo a singulation process in which each of the dies 2002 is separated from one another to provide discrete "chips" of the semiconductor product. In particular, devices performance enhanced by local layout effect as disclosed herein may take the form of the wafer 2000 (e.g., not singulated) or the form of the die 2002 (e.g., singulated). The die 2002 may include one or more diodes, one or more transistors as well as, optionally, supporting circuitry to route electrical signals to the III-N diodes with n-doped wells and capping layers and III-N transistors, as well as any other IC components. In some embodiments, the wafer 2000 or the die 2002 may implement an electrostatic discharge (ESD) protection device, a radio frequency front-end device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 7 is a side, cross-sectional view of an example IC package 2200 that may include one or more IC devices with performance-enhancing layout, according to some embodiments of the disclosure. In some embodiments, the IC package 2200 may be a system-in-package (SiP).

As shown in FIG. 7, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 7 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 7 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

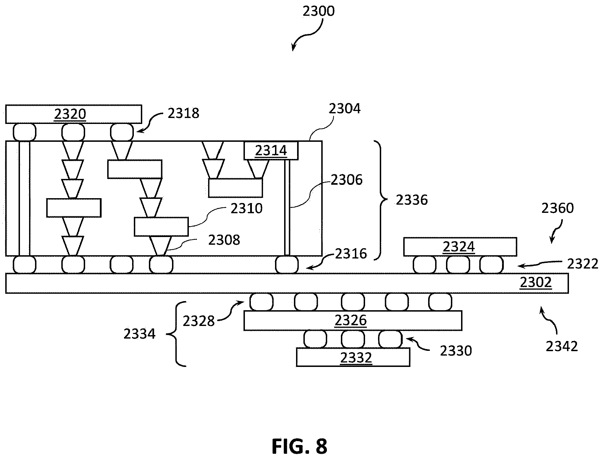

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 7 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 8.

The dies 2256 may take the form of any of the embodiments of the die 2002 discussed herein and may include any of the embodiments of an IC device with performance-enhancing layout. In embodiments in which the IC package 2200 includes multiple dies 2256, the IC package 2200 may be referred to as a multichip package. Importantly, even in such embodiments of an MCP implementation of the IC package 2200, one or more IC devices with performance-enhancing layout may be provided in a single chip, in accordance with any of the embodiments described herein. The dies 2256 may include circuitry to perform any desired functionality. For example, one or more of the dies 2256 may be ESD protection dies, including one or more IC devices with performance-enhancing layout as described herein, one or more of the dies 2256 may be logic dies (e.g., silicon-based dies), one or more of the dies 2256 may be memory dies (e.g., high bandwidth memory), etc. In some embodiments, any of the dies 2256 may include or otherwise be associated with one or more component with performance-enhancing layout, e.g., as discussed above; in some embodiments, at least some of the dies 2256 may not include any III-N diodes with n-doped wells and capping layers.

The IC package 2200 illustrated in FIG. 7 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 7, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 8 is a cross-sectional side view of an IC device assembly 2300 that may include components having one or more IC devices with performance-enhancing layout, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices with performance-enhancing layout in accordance with any of the embodiments disclosed herein; e.g., any of the IC packages discussed below with reference to the IC device assembly 2300 may take the form of any of the embodiments of the IC package 2200 discussed above with reference to FIG. 7 (e.g., may include one or more component with performance-enhancing layout in/on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 8 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 8), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 6B), an IC device (e.g., the IC device of FIGS. 1-2), or any other suitable component. In particular, the IC package 2320 may include one or more devices with performance-enhancing layout as described herein. Although a single IC package 2320 is shown in FIG. 8, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 8, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to TSVs 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF (radio frequency) devices, power amplifiers, power management devices, antennas, arrays, sensors, and microelectromechanical systems (MEMS) devices may also be formed on the interposer 2304. In some embodiments, the IC devices with performance-enhancing layout as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 8 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

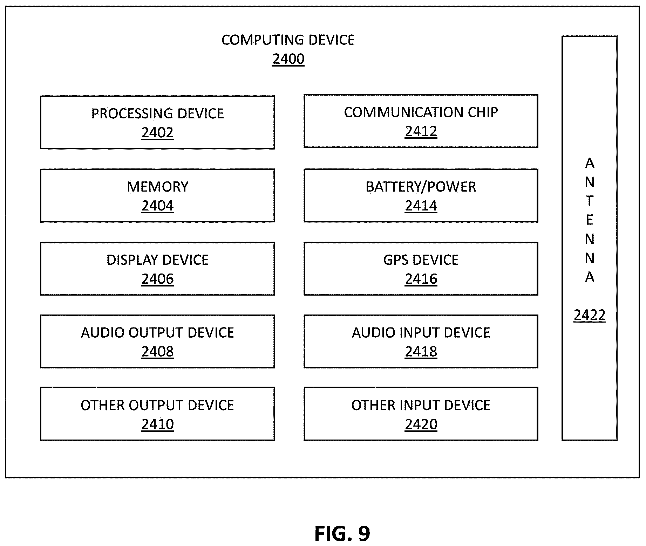

FIG. 9 is a block diagram of an example computing device 2400 that may include one or more components with one or more IC devices with performance-enhancing layout, according to some embodiments of the disclosure. For example, any suitable ones of the components of the computing device 2400 may include a die (e.g., the die 2002 of FIG. 6B) including or associated with devices with performance-enhancing layout, according to some embodiments of the disclosure. Any of the components of the computing device 2400 may include an IC device with performance-enhancing layout (e.g., any embodiment of the IC devices described above in conjunction with FIGS. 1 and 3-5) and/or an IC package (e.g., the IC package 2200 of FIG. 7). Any of the components of the computing device 2400 may include an IC device assembly (e.g., the IC device assembly 2300 of FIG. 8).

A number of components are illustrated in FIG. 9 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC (system-on-chip) die.

Additionally, in various embodiments, the computing device 2400 may not include one or more of the components illustrated in FIG. 9, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices with performance-enhancing layout as described herein may be particularly advantageous for use as part of ESD circuits protecting power amplifiers, low-noise amplifiers, filters (including arrays of filters and filter banks), switches, or other active components. In some embodiments, IC devices with performance-enhancing layout as described herein may be used in PMICs, e.g., as a rectifying diode for large currents. In some embodiments, IC devices with performance-enhancing layout as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include another output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include another input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device, including a transistor including a source region, a drain region, and a gate electrode between the source region and the drain region in a first direction; and an assembly including a first semiconductor region, a second semiconductor region, and a dielectric structure between the first semiconductor region and the second semiconductor region in the first direction, where the dielectric structure is over the gate electrode in a second direction that is perpendicular or substantially perpendicular to the first direction.

Example 2 provides the IC device according to example 1, further including an additional transistor including an additional gate electrode, where the additional gate electrode is separated from the gate electrode by an electrical insulator.

Example 3 provides the IC device according to example 2, where the additional gate electrode is over the gate electrode in the second direction.

Example 4 provides the IC device according to any of the preceding examples, further including a conductive structure over the transistor and the assembly in the first direction.

Example 5 provides the IC device according to example 4, further including an additional conductive structure, where the transistor is between the conductive structure and the additional conductive structure in the first direction.

Example 6 provides the IC device according to any of the preceding examples, where the source region or the drain region is in a first support structure, the first semiconductor region or the second semiconductor region is in a second support structure, and the second support structure is over the first support structure in the second direction.

Example 7 provides the IC device according to any of the preceding examples, where the dielectric structure includes nitrogen.

Example 8 provides an IC device, including a group of transistors, an individual transistor including a gate electrode and a channel region; a group of support structures, an individual support structure including the channel region of the individual transistor; and a conductive structure extending across the group of support structures in a direction, where the transistors are over each other in the direction, and gate electrodes of the transistors are separated from each other by one or more electrical insulators.

Example 9 provides the IC device according to example 8, where the group of transistors is a first group of transistors, the direction is a first direction, the IC device further includes a second group of transistors that is over the first group of transistors in a second direction, and the second direction is perpendicular or substantially perpendicular to the first direction.

Example 10 provides the IC device according to example 9, where the conductive structure is between the first group of transistors and the second group of transistors in the second direction.

Example 11 provides the IC device according to example 9 or 10, where an individual transistor in the second group includes a gate electrode and a channel region, and the individual support structure includes the channel region of the individual transistor in the second group.

Example 12 provides the IC device according to example 11, where gate electrodes of the transistors in the second group are separated from each other by one or more electrical insulators.

Example 13 provides the IC device according to any one of examples 8-12, where the direction is a first direction, the gate electrode is over a dielectric structure in the first direction, and the dielectric structure is between semiconductor regions in a second direction that is perpendicular or substantially perpendicular to the first direction.

Example 14 provides the IC device according to example 13, where the individual transistor including a source region and a drain region, and the source region and drain region are over the semiconductor regions, respectively, in the first direction.

Example 15 provides an IC device, including a first semiconductor region; a second semiconductor region; a first conductive structure between the first semiconductor region and the second semiconductor region in a first direction; and a second conductive structure, the second conductive structure longer than the first conductive structure in a second direction that is perpendicular or substantially perpendicular to the first direction, where the first semiconductor region is between the first conductive structure and the second conductive structure in the first direction.

Example 16 provides the IC device according to example 15, further including a first transistor including the first semiconductor region, the second semiconductor region, and the first conductive structure; and a second transistor over the first transistor in the second direction, the second transistor including a source region, a drain region, and a gate electrode, where the gate electrode is separated from the first conductive structure by an electrical insulator.

Example 17 provides the IC device according to example 16, where the source region or the drain region is over the first semiconductor region or the second semiconductor region in the second direction.

Example 18 provides the IC device according to any one of examples 15-17, where the first conductive structure is electrically coupled to a power plane, and the second conductive structure is separated from the power plane by an electrical insulator.

Example 19 provides the IC device according to any one of examples 15-18, further including a dielectric structure between semiconductor regions in the first direction, where the dielectric structure is over the first conductive structure in the second direction.

Example 20 provides the IC device according to any one of examples 15-19, where the second conductive structure is longer than a total length of the first conductive structure and the dielectric structure in the second direction.

Example 21 provides an IC package, including the IC device according to any one of examples 1-14; and a further IC component, coupled to the device.

Example 22 provides the IC package according to example 21, where the further IC component includes one of a package substrate, an interposer, or a further IC die.

Example 23 provides the IC package according to example 21 or 22, where the IC device according to any one of examples 1-20 may include, or be a part of, at least one of a memory device, a computing device, a wearable device, a handheld electronic device, and a wireless communications device.

Example 24 provides an electronic device, including a carrier substrate; and one or more of the IC devices according to any one of examples 1-20 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

Example 34 provides processes for forming the IC device according to any one of claims 1-20.

Example 35 provides processes for forming the IC package according to any one of the claims 21-23.

Example 36 provides processes for forming the electronic device according to any one of the claims 24-33.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a transistor comprising:
a source region,
a drain region, and
a gate electrode between the source region and the drain region in a first direction; and an assembly comprising:
a first semiconductor region,
a second semiconductor region, and
a dielectric structure between the first semiconductor region and the second semiconductor region in the first direction,
wherein the dielectric structure is over the gate electrode in a second direction that is perpendicular or substantially perpendicular to the first direction.

2. The IC device according to claim 1, further comprising:
an additional transistor comprising an additional gate electrode,
wherein the additional gate electrode is separated from the gate electrode by an electrical insulator.

3. The IC device according to claim 2, wherein the additional gate electrode is over the gate electrode in the second direction.

4. The IC device according to any one of claims 1-3, further comprising:
a conductive structure over the transistor and the assembly in the first direction; and
an additional conductive structure, wherein the transistor is between the conductive structure and the additional conductive structure in the first direction.

5. The IC device according to any one of claims 1-4, wherein:
the source region or the drain region is in a first support structure,
the first semiconductor region or the second semiconductor region is in a second support structure, and
the second support structure is over the first support structure in the second direction.

6. An integrated circuit (IC) device, comprising:
a group of transistors, an individual transistor comprising a gate electrode and a channel region;
a group of support structures, an individual support structure comprising the channel region of the individual transistor; and
a conductive structure extending across the group of support structures in a direction,
wherein:
the transistors are over each other in the direction, and
gate electrodes of the transistors are separated from each other by one or more electrical insulators.

7. The IC device according to claim 6, wherein:
the group of transistors is a first group of transistors,
the direction is a first direction,
the IC device further comprises a second group of transistors that is over the first group of transistors in a second direction, and
the second direction is perpendicular or substantially perpendicular to the first direction.

8. The IC device according to claim 7, wherein:
the conductive structure is between the first group of transistors and the second group of transistors in the second direction; or
an individual transistor in the second group comprises a gate electrode and a channel region, and the individual support structure comprises the channel region of the individual transistor in the second group.

9. The IC device according to claim 8, wherein gate electrodes of the transistors in the second group are separated from each other by one or more electrical insulators.

10. The IC device according to any one of claims 6-9, wherein:
the direction is a first direction,
the gate electrode is over a dielectric structure in the first direction, and
the dielectric structure is between semiconductor regions in a second direction that is perpendicular or substantially perpendicular to the first direction.

11. The IC device according to claim 10, wherein the individual transistor comprising a source region and a drain region, and the source region and drain region are over the semiconductor regions, respectively, in the first direction.

12. An integrated circuit (IC) device, comprising:
a first semiconductor region;
a second semiconductor region;
a first conductive structure between the first semiconductor region and the second semiconductor region in a first direction; and
a second conductive structure, the second conductive structure longer than the first conductive structure in a second direction that is perpendicular or substantially perpendicular to the first direction,
wherein the first semiconductor region is between the first conductive structure and the second conductive structure in the first direction.

13. The IC device according to claim 12, further comprising:
a first transistor comprising the first semiconductor region, the second semiconductor region, and the first conductive structure; and
a second transistor over the first transistor in the second direction, the second transistor comprising a source region, a drain region, and a gate electrode,
wherein the gate electrode is separated from the first conductive structure by an electrical insulator, and the source region or the drain region is over the first semiconductor region or the second semiconductor region in the second direction.

14. The IC device according to claim 12 or 13, wherein the first conductive structure is electrically coupled to a power plane, and the second conductive structure is separated from the power plane by an electrical insulator.

15. The IC device according to any one of claims 12-14, further comprising:
a dielectric structure between semiconductor regions in the first direction,
wherein the dielectric structure is over the first conductive structure in the second direction, and the second conductive structure is longer than a total length of the first conductive structure and the dielectric structure in the second direction.
